# EUROPÄISCHE PATENTSCHRIFT

(11) **EP 1 568 259 B1**
(45) Veröffentlichungstag und Bekanntmachung des Hinweises auf die Patenterteilung: **28.02.2007**
(21) Anmeldenummer: 03785692.9
(22) Anmeldetag: 01.12.2003
(51) Int. Cl.: H05K 7/14

(54) **SIGNALVERARBEITUNGSEINHEIT FÜR DIE PROZESSAUTOMATISIERUNGSTECHNIK ZUR MONTAGE AN EINER HUTSCHIENE**
SIGNAL PROCESSING UNIT FOR USE IN PROCESS AUTOMATION TECHNOLOGY TO BE MOUNTED ON A TOP-HAT RAIL
UNITÉ DE TRAITEMENT DE SIGNAL D' UN AUTOMATE INDUSTRIEL DESTINÉE À ÊTRE MONTÉE SUR UN RAIL EN FORME DE CHAPEAU

(30) Priorität: 03.12.2002 DE 10256648
(43) Veröffentlichungstag der Anmeldung: 31.08.2005
(73) Patentinhaber: ENDRESS + HAUSER WETZER GmbH + Co. KG, D-87484 Nesselwang (DE)
(72) Erfinder: SCHMIDT, Dieter, 87484 Nesselwang (DE); SANDLER, Thomas, 87645 Schwangau (DE)
(74) Vertreter: Andres, Angelika Maria
(86) Internationale Anmeldenummer: PCT/EP2003/013490
(87) Internationale Veröffentlichungsnummer: WO 2004/052064

(56) Entgegenhaltungen:
- EP-A- 0 194 962
- DE-C- 4 309 336
- DE-C- 4 410 171
- US-A- 4 573 104
- US-A1- 2002 063 099

## Beschreibung

Die Erfindung betrifft eine Signalverarbeitungseinheit für die Prozessautomatisierungstechnik zur Montage an einer Hutschiene gemäß dem Oberbegriff des Anspruchs 1.

In der Prozessautomatisierungstechnik werden häufig Registriergeräte eingesetzt, die zur Dokumentation, Überwachung und Visualisierung von Messstellen dienen. Neuere Registriergeräte sind in der Regel prozessorgesteuert und weisen häufig eine Verbindung zu Leitsystemen auf. Die Verbindung erfolgt meist über ein Feldbus. Beispiele für derartige Feldbusse sind, Profibus®, Foundation Fieldbus®, CAN-Bus® etc..

Diese Registriergeräte weisen in der Regel ein Gehäuse mit mehreren Steckkarten auf, z. B. eine Steckkarte mit einem Mikroprozessor (CPU-Karte), Steckkarten mit analogen bzw. digitalen Ein- u. Ausgängen (I-O-Karten) und eine Steckkarte für das Netzteil.

Um die Messwerte zu visualisieren ist eine Anzeigeeinheit vorgesehen, die mit dem Gehäuse verbunden ist und aus einem Rahmen besteht, der zur Aufnahme eines Displays, der Tastatur und mindestens einer Leiterplatte dient. Derartige Registriergeräte sind häufig in Schalttafeln eingebaut und werden deshalb auch als Schalttafeleinbaugeräte bezeichnet. Ein Beispiel für ein derartiges Schalttafeleinbaugerät ist das Produkt memo-graph von der Firma Endress + Hauser.

Neben Schalttafeleinbaugeräten werden in der Prozessautomatisierungstechnik auch häufig sogenannte Hutschienengeräte eingesetzt. Derartige Geräte sind besonders einfach auf einer Hutschiene zu montieren.

Häufig ist es erwünscht, Schalttafeleinbaugeräte auch zur Montage an einer Hutschiene auszubilden.

Insbesondere bei Registriergeräten, die als Schalttafeleinbaugeräte ausgebildet sind, ist die Montage einer Hutschiene nur sehr aufwendig zu realisieren. In der Regel ist eine Neukonstruktion einfacher zu bewerkstelligen als eine Umkonstruktion bestehender Registriergeräte.

Mit Neukonstruktionen sind jedoch erhebliche Kosten verbunden.

Aufgabe der Erfindung ist es deshalb eine Signalverarbeitungseinheit für die Prozessautomatisierungstechnik zur Montage an einer Hutschiene anzugeben, die auf einem vorhandenen Registriergerät, das als Schalttafeleinbaugerät ausgebildet ist basiert und die einfach und kostengünstig ohne teuere Konstruktionsmaßnahmen fertigbar ist.

Gelöst wird diese Aufgabe durch die im Anspruch 1 angegebene Signalverarbeitungseinheit für die Prozessautomatisierungstechnik zur Montage an einer Hutschiene.

Vorteilhafte Weiterentwicklung der Erfindung sind in den Unteransprüchen angegeben.

Nachfolgend ist die Erfindung anhand eines in der Zeichnung dargestellten Ausführungsbeispiels näher erläutert.

Es zeigen:
- Fig. 1: Signalverarbeitungseinheit mit Adaptionsmodul in perspektivischer Darstellung;
- Fig. 2: Rückansicht der Signalverarbeitungseinheit gemäß Fig. 1 in perspektivischer Darstellung;
- Fig.: 3 Adaptionsmodul gemäß Fig. 1 in perspektivischer Darstellung;
- Fig. 4: Rückansicht des Adaptionsmodul gemäß Fig. 3.

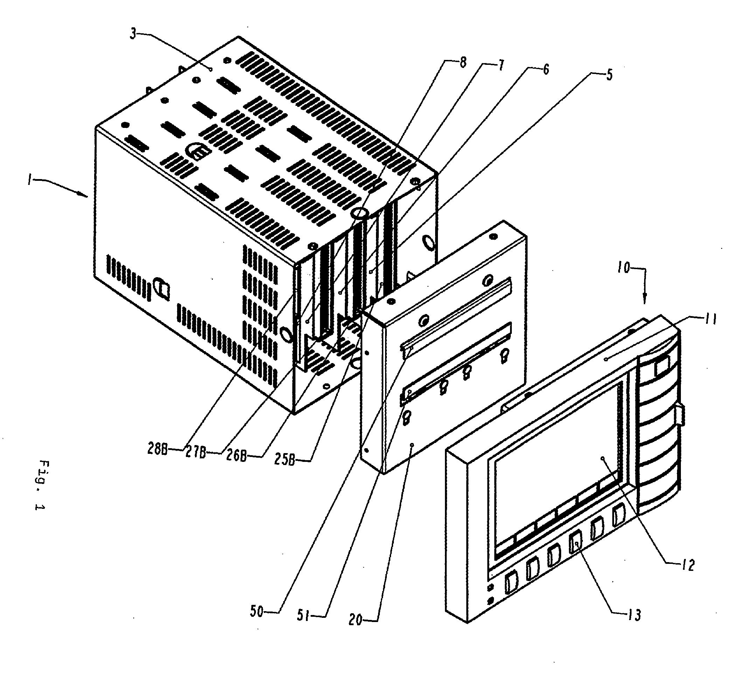

Fig. 1 zeigt eine Signalverarbeitungseinheit 1 für die Prozessautomatisierungstechnik zur Montage an einer Hutschiene mit einem Gehäuse 3, das zur Aufnahme mehrerer Steckkarten 5, 6, 7, 8 (CPU-Karte, I-O-Karten, Netzteil- Karte) dient.
Auf der Rückseite des Gehäuses 3 sind zur Verbindung mit anderen Rechnereinheiten zwei Schnittstellen S1 bzw. S2 vorgesehen.

Mit dem Gehäuse 3 ist ein Adaptionsmodul 20 verbindbar.
Das Adaptionsmodul 20 ist im abgenommenen Zustand dargestellt und weist zwei Winkelbleche 50 bzw. 51 auf.
Neben dem Adaptionsmodul 20 ist eine Anzeigeeinheit 10 dargestellt, die ebenfalls mit dem Gehäuse 3 verbindbar ist.
In Verbindung mit der Anzeigeeinheit 10 stellt die Signalverarbeitungseinheit 1 ein an sich bekanntes Registriergerät dar, das zum Einbau in eine Schalttafel geeignet ist.
Die Anzeigeeinheit 10 besteht im wesentlichen aus einem Rahmen 11 mit einem Display 12 und einer Tastatur 13. Im Display 12 können z. B. Messkurven dargestellt werden. Über die Tastatur 13 sind Eingaben möglich.

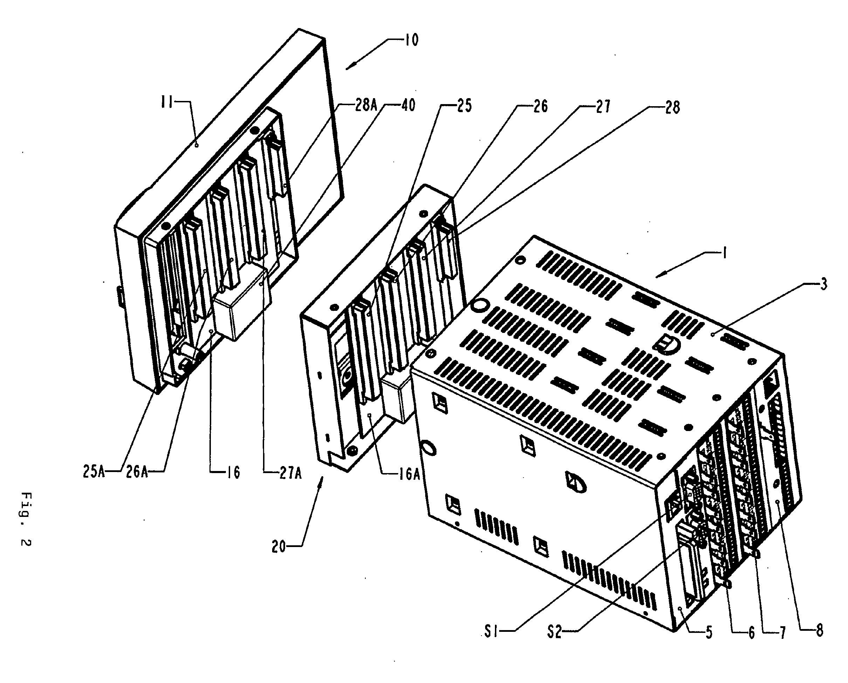

Die Anzeigeeinheit 10 weist eine Leiterplatte 16 auf, die in Fig. 2 besser zu sehen ist. Die Leiterplatte 16 weist mehrere Buchsenleisten 25A, 26A, 27A, 28A, sowie eine Auswerteelektronik 40 für das Display 12 auf.

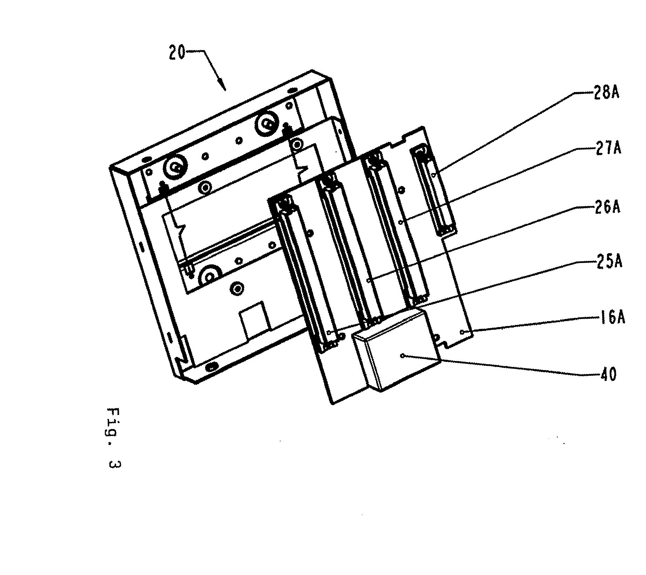

Fig. 3 zeigt eine Rückansicht des Adaptionsmoduls 20 mit abgenommener Leiterplatte 16A.

Nachfolgend ist die Funktionsweise der Erfindung näher erläutert. Durch einfaches Ersetzen der Anzeigeeinheit 10 durch das Adaptionsmodul 20 kann ein vorhandenes Registriergerät für die Schalttafelmontage in eine Signalverarbeitungseinheit für die Prozessautomatisierungstechnik zur Montage an einer Hutschiene umgewandelt werden. Beim Aufsetzen des Adaptionsmoduls 20 auf das Gehäuse 3 wird die Verbindung der Steckkarten durch die Buchsenleisten 25, 26, 27, 28 automatisch hergestellt. Die Steckerleisten 25B, 26B, 27B, 28B auf den Steckkarten 5, 6, 7, 8 bzw. auf der Leiterplatte 25A, 26A, 27A, 28A sind deshalb passend zueinander angeordnet.

Die erfindungsgemäße Signalverarbeitungseinheit 1 ist besonders für unzugängliche Einsatzorte wie z. B. Pumpstationen geeignet, da bei einem derartigen Einsatz die Visualisierung der Messwerte nur eine geringe Bedeutung für den Anwender besitzt. In der Regel werden die Messwerte in einer entfernten Rechnereinheit, die über die Schnittstellen S1 bzw. S2 oder per Modemverbindung mit der Signalverarbeitungseinheit verbunden ist dargestellt. Über diese Rechnereinheit können auch Einstellungen an der Signalverarbeitungseinheit 1 vorgenommen werden, da beim Adaptionsmodul 20 keine Tastatur mehr vorhanden ist. Die Leiterbahnen auf der Leiterplatte 16 bzw. 16A dienen zur elektrischen Verbindung der Steckkarten 5, 6, 7, 8.

Da bei dem Adaptionsmodul 20 kein Display vorgesehen ist, kann auf die Display Aussteuerelektronik 40 verzichtet werden, dadurch ist das Adaptionsmodul 20 noch kostengünstiger herstellbar.

Durch die federnd gelagerten Winkelbleche 50, 51 ist eine einfache Rastverbindung auf einer Hutschiene möglich.

Da die Signalverarbeitungseinheit 1 ein erhebliches Gewicht hat, ist das Adaptionsmodul 20 mit den Winkelblechen 50, 51 aus Stahlblech gefertigt, um eine sichere Montage an einer Hutschine zu gewährleisten.

### Bezugszeichenliste

- 1: Signalverarbeitungseinheit
- 3: Gehäuse
- 5, 6, 7, 8: Steckkarten
- 10: Anzeigeeinheit
- 11: Rahmen
- 12: Display
- 13: Tastatur
- 16, 16A: Leiterplatte
- 20: Adaptionsmodul

- 25,26,27, 28, 25A, 26A, 27A, 28A: Buchsenleisten

- 25B, 26B, 27B, 28B: Steckerleisten

- 40: Display-Aussteuerelektronik
- 50 bzw. 51: Winkelbleche

- S1 bzw. S2: Schnittstellen

## Patentansprüche

1. Signalverarbeitungseinheit für die Prozessautomatisierungstechnik zur Montage an einer Hutschiene, mit einem Gehäuse (3) zur Aufnahme mehrerer Steckkarten (5, 6, 7 ,8), z. B. CPU-Karte, I/O-Karten, Netzteil-Karte, das mit einer Anzeigeeinheit (10) bestehend aus einem Rahmen (11) mit Display (12), Tastatur (14) und Leiterplatte (16) zu einem Schalttafeleinbaugerät verbindbar ist, wobei Leiterbahnen der Leiterplatte (16) zur elektrischen Verbindung der Steckkarten (5, 6, 7, 8) dienen,
**dadurch gekennzeichnet,**
**dass** das Gehäuse (3) mit einem Adaptionsmodul (20) verbunden ist, das zur Befestigung an einer Hutschiene dient und eine Leiterplatte (16A) aufweist, deren Leiterbahnen entsprechend den Leiterbahnen der Leiterplatte (16) der Anzeigeeinheit (10) ausgebildet sind.

2. Signalverarbeitungseinheit nach Anspruch 1, **dadurch gekennzeichnet, dass** an den Steckkarten (5, 6, 7, 8) und den Leiterplatten (16, 16A) Buchsenleisten (25, 26, 27, 28; 25A, 26A, 27A, 28A) vorgesehen sind, die passend zu den Steckerleisten (25B, 26B, 27B, 28B) angeordnet sind, um beim Aufsetzen des Adaptionsmoduls (20) bzw. der Anzeigeeinheit (10) auf das Gehäuse (3) die Verbindungen zwischen den Steckkarten (5, 6, 7, 8) herzustellen.

3. Signalverarbeitungseinheit nach einem der vorhergehenden Ansprüche, **dadurch gekennzeichnet, dass** die Leiterplatte (16A) keine Display-Aussteuerelektronik (40) für das Display (12) aufweist.

4. Signalverarbeitungseinheit nach einem der vorhergehenden Ansprüche, **dadurch gekennzeichnet, dass** das Adaptionsmodul (20) zwei Winkelbleche (50, 51) aufweist von denen mindestens eines federnd gelagert ist und als Rastverbindung mit einer Hutschiene dienen.

5. Signalverarbeitungseinheit nach einem der vorhergehenden Ansprüche,
**dadurch gekennzeichnet, dass** das Adaptionsmodul (20) aus Stahlblech gefertigt ist.

## Claims

1. Signal processing unit for process automation technology for mounting on a top-hat rail, having a housing (3) for receiving a plurality of plug-in cards (5, 6, 7, 8), e.g. CPU card, I/O cards, power supply card, which housing is connectable to a display unit (10) comprising a frame (11) with a display (12), keypad (14) and printed circuit board (16) to form a panel-mounting device, conducting tracks of the printed circuit board (16) serving for electrical connection of the plug-in cards (5, 6, 7, 8),
**characterised**
**in that** the housing (3) is connected to an adaptation module (20) which serves for securing to a top-hat rail and has a printed circuit board (16A), the conducting tracks of which are designed correspondingly to the conducting tracks of the printed circuit board (16) of the display unit (10).

2. Signal processing unit according to Claim 1, **characterised in that** edge socket connectors (25, 26, 27, 28; 25A, 26A, 27A, 28A) are provided on the plug-in cards (5, 6, 7, 8) and the printed circuit boards (16, 16A), which connectors are arranged to fit the edge plug connectors (25B, 26B, 27B, 28B), in order to produce the connections between the plug-in cards (5, 6, 7, 8) when placing the adaptation module (20) or the display unit (10) onto the housing (3).

3. Signal processing unit according to one of the preceding claims, **characterised in that** the printed circuit board (16A) has no display drive electronics (40) for the display (12).

4. Signal processing unit according to one of the preceding claims, **characterised in that** the adaptation module (20) has two angle plates (50, 51), at least one of which is resiliently mounted and serves as a snap-on connection to a top-hat rail.

5. Signal processing unit according to one of the preceding claims, **characterised in that** the adaptation module (20) is produced from sheet steel.

## Revendications

1. Unité de traitement de signaux pour la technique d'automatisation de process, destinée au montage sur un rail profilé, avec un boîtier (3) servant au logement de plusieurs cartes enfichables (5, 6, 7, 8), par exemple une carte UC, des cartes E/S, une carte d'alimentation, qui peut être relié avec une unité d'affichage (10) constituée d'un cadre (11) avec afficheur (12), d'un clavier (14) et d'un circuit imprimé (16), en tant qu'un appareil à monter en armoire, les pistes du circuit imprimé (16) servant à la liaison électrique des cartes enfichables (5, 6, 7, 8), **caractérisée en ce**
**que** le boîtier (3) est relié avec un module d'adaptation (20), qui sert à la fixation sur un rail profilé et comporte un circuit imprimé (16A), dont les pistes sont conçues de façon adaptée aux pistes du circuit imprimé (16) de l'unité d'affichage (10).

2. Unité de traitement de signaux selon la revendication 1, **caractérisée en ce que** sont prévues, sur les cartes enfichables (5, 6, 7, 8) et les circuits imprimés (16, 16A), des connecteurs femelles (25, 26, 27, 28 ; 25A, 26A, 27A, 28A), qui sont disposés de façon appropriée par rapport aux connecteurs mâles (25B, 26B, 27B, 28B), afin d'établir les liaisons électriques avec les cartes enfichables (5, 6, 7, 8) lors de la mise en place du module d'adaptation (20) ou de l'unité d'affichage (10) sur le boîtier (3).

3. Unité de traitement de signaux selon l'une des revendications précédentes, **caractérisée en ce que** le circuit imprimé (16A) ne comporte aucun module électronique de gestion (40) de l'afficheur (12).

4. Unité de traitement de signaux selon l'une des revendications précédentes, **caractérisée en ce que** le module d'adaptation (20) comporte deux tôles d'angle (50, 51), dont au moins l'une d'entre elles est montée sur ressort et sert de connexion encliquetable avec un rail profilé.

5. Unité de traitement de signaux selon l'une des revendications précédentes, **caractérisée en ce que** le module d'adaptation (20) est fabriqué en tôle d'acier.
